# DEMANDE DE BREVET EUROPEEN

(11) **EP 2 091 086 A2**
(43) Date de publication de la demande: **19.08.2009**
(21) Numéro de dépôt: 09156836.0
(22) Date de dépôt: 18.01.2006
(51) Int. Cl.: H01L 31/0352, H01L 31/20, H01L 31/072, H01L 31/0288

(54) **Dispositif semi-conducteur a heterojonctions**

(30) Priorité: 20.01.2005 FR 0550174
(62) Demande divisionnaire de: 06709408.6
(71) Demandeur: COMMISSARIAT A L'ENERGIE ATOMIQUE, 75015 Paris (FR)
(72) Inventeur: Roca i Cabarrocas, Pere, 91140 Villebon sur Yvette (FR); Damon-Lacoste, Jerome, 92340 Bourg La reine (FR)
(74) Mandataire: Texier, Christian

(57) **Abrégé**

Dispositif semi-conducteur comprenant, sur au moins une face d'une couche en un matériau semi-conducteur cristallin d'un certain type de conductivité, une couche en un matériau semi-conducteur amorphe, dopé d'un type de conductivité opposé au type de conductivité de la couche d'un matériau semi-conducteur cristallin, **caractérisé en ce que** la concentration des éléments dopants varie graduellement dans la couche de semi-conducteur amorphe.

## Description

### DOMAINE TECHNIQUE

La présente invention se rapporte à un dispositif semi-conducteur à hétérojonctions tel que décrit dans la revendication 1.

### ÉTAT DE LA TECHNIQUE ANTÉRIEURE

Actuellement, plusieurs types de technologie sont utilisés pour la réalisation de dispositifs à semi-conducteurs. Dans la fabrication des cellules solaires, deux types de technologie sont principalement utilisés : les cellules à homojonctions, et les cellules à hétérojonctions.

Le principe de l'hétérojonction amorphe / cristallin est déjà connu. Des cellules solaires 10 reprenant ce principe ont déjà été brevetées. Le principe de ce type de cellule est d'utiliser un substrat de semi-conducteur cristallin dopé d'un premier type de conductivité. Sur une de ses faces, un semi-conducteur amorphe dopé d'un second type de conductivité opposé au premier type de conductivité, vient alors en contact. On obtient alors une jonction PN appelée hétérojonction, car les deux semiconducteurs utilisés sont de composition atomique différente et n'ont pas la même largeur de bande interdite. Il suffit alors de réaliser une électrode transparente sur une première face de la jonction et, sur une seconde face opposée à cette première face, de réaliser une électrode de contact ohmique pour obtenir une cellule solaire à hétérojonction.

Par rapport aux cellules à homojonctions, il y a tout d'abord un avantage de coût car le procédé de fabrication est réalisé à basse température. Cela permet d'éviter les inconvénients décrits précédemment apparaissant lors des procédés à haute température. Cette technologie permet également de fabriquer des cellules plus fines sans risque de stress thermique, et donc de détérioration. Enfin, lorsque les semiconducteurs utilisés sont du silicium, cette structure à hétérojonction permet d'utiliser une variété plus large de silicium cristallin car il n'y a pas de dégradation de la durée de vie liée aux traitements thermiques à haute température.

Le brevet US 5 066 340 décrit une cellule solaire à hétérojonction. Celle-ci comporte une jonction PN formée par un substrat de silicium cristallin d'un premier type de conductivité et une couche de silicium amorphe d'un second type de conductivité, opposé au premier type de conductivité, réalisée sur une des faces du substrat cristallin. Cette cellule intègre également, entre le substrat cristallin et la couche de silicium amorphe, une couche de silicium microcristallin intrinsèque. Le brevet US 5 213 628 décrit également une cellule solaire à hétérojonction. Comme dans le brevet US 5 066 340, cette cellule comporte une hétérojonction formée par un substrat de silicium cristallin d'un premier type de conductivité et une couche de silicium amorphe d'un second type de conductivité, opposé au premier type de conductivité, réalisée sur une des faces du substrat cristallin. Cette cellule intègre, entre le substrat cristallin et la couche de silicium amorphe, une couche de silicium amorphe intrinsèque.

### EXPOSÉ DE L'INVENTION

La présente invention a pour but de proposer un dispositif semi-conducteur à hétérojonctions comprenant une couche de semi-conducteur amorphe présentant un bon état d'interface avec le substrat semi-conducteur.

A cet effet, l'invention propose un dispositif semi-conducteur tel que décrit par la revendication 1.

Le dispositif selon l'invention est avantageusement complété par les caractéristiques mentionnées dans les revendications 2 à 8, prises seules ou en une quelconque de leur combinaison techniquement possible.

L'invention concerne également un procédé tel que décrit par la revendication 9.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1A représente en coupe un dispositif semi-conducteur selon l'invention,
- la figure 1B représente une vue de dessous d'un dispositif semi-conducteur selon l'invention,
- la figure 1C représente en coupe un dispositif semi-conducteur selon l'invention,
- les figures 2, 3, 4A, 4B et 4C illustrent différentes étapes d'un procédé selon l'invention pour la réalisation d'un dispositif semi-conducteur selon l'invention,
- les figures 5, 6, 7A et 7B illustrent différentes étapes d'un procédé selon l'invention pour la réalisation d'un dispositif semi-conducteur selon l'invention,

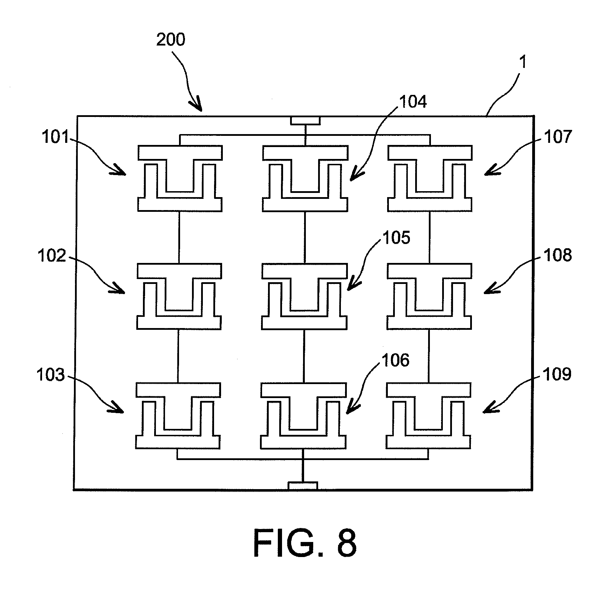

- la figure 8 représente une vue de dessous 15 d'un module formé de plusieurs cellules solaires reliées entre elles, également objet de la présente invention.

Des parties identiques, similaires ou équivalentes des différentes figures décrites ci-après 20 portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

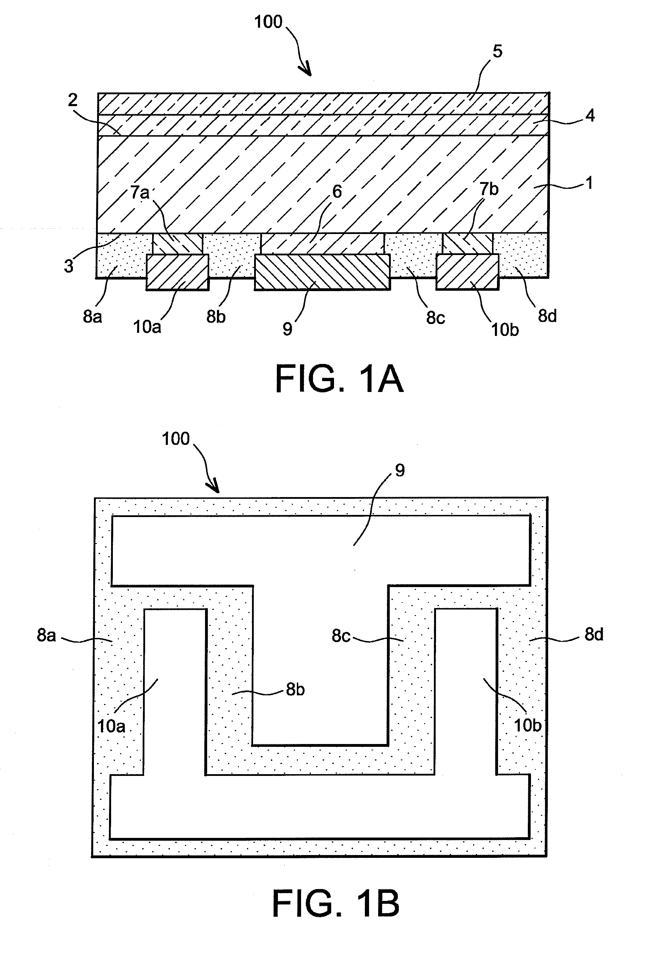

On se réfère à la figure 1A qui montre en coupe un exemple de dispositif semi-conducteur 100 à hétérojonctions et à structure inter-digitée, objet de la présente invention. Le dispositif semi-conducteur 100 comporte, sur au moins une face 3 d'un substrat semi-conducteur 1 cristallin, au moins une première région 6 de semi-conducteur amorphe. Cette première région 6 est dopée d'un premier type de conductivité. Le substrat semi-conducteur 1 comporte également sur la face 3 au moins une seconde région 7a, 7b de semiconducteur amorphe. Cette seconde région 7a, 7b est dopée d'un second type de conductivité, opposé au premier type de conductivité. Ces régions 6, 7a, 7b de semi-conducteur amorphe forment une structure inter-digitée. Dans cet exemple, le dispositif semiconducteur 100 une cellule solaire.

Le dispositif semi-conducteur 100 comporte le substrat semi-conducteur 1 que l'on suppose dans cet exemple en couche mince. Ce substrat semi-conducteur 1 peut être par exemple en silicium monocristallin ou polycristallin. Il n'est pas nécessaire d'utiliser un silicium de très bonne qualité car, du fait de l'absence de fortes contraintes thermiques pendant le procédé de réalisation du dispositif semi-conducteur 100, le silicium ne verra pas la durée de vie de ses porteurs de charge altérée. L'épaisseur du substrat semi-conducteur 1 en couche mince peut être comprise par exemple entre environ 10 micromètres et quelques centaines de micromètres. Le substrat semi-conducteur 1 peut être d'un certain type de conductivité. Dans l'exemple illustré de la figure 1A, le substrat semiconducteur 1 est de type N.

Le substrat semi-conducteur 1 comporte la face 3 qui dans cet exemple est du côté de la face arrière de la cellule solaire. Le substrat semi-conducteur 1 comporte une autre face 2, opposée à la face 3, qui est du côté de la face avant de la cellule solaire. C'est la face avant de la cellule solaire qui est exposée à la lumière.

Le substrat semi-conducteur 1 comporte, sur la face 3, au moins une première région 6 de semiconducteur amorphe dopé d'un premier type de conductivité. Dans l'exemple illustré sur la figure 1A, le substrat semi-conducteur 1 comporte sur la face 3 une seule première région 6. Cette première région 6 est par exemple du silicium amorphe dopé N. L'épaisseur de la première région 6 de semi-conducteur amorphe peut être comprise par exemple entre environ quelques nanomètres et quelques dizaines de nanomètres. La première région 6 de semi-conducteur amorphe peut être graduellement dopée (dopage le plus faible près de la face 3 du substrat 1) afin d'assurer un bon état d'interface avec le substrat semi-conducteur 1.

Le substrat semi-conducteur 1 comporte également sur la face 3, au moins une seconde région 7a, 7b de semi-conducteur amorphe dopée d'un second type de conductivité, opposé au premier type de conductivité. Dans l'exemple illustré sur la figure 1A, le substrat semi-conducteur 1 comporte sur la face 3 deux secondes régions 7a, 7b, réalisées de part et d'autres de la première région 6. On suppose que ces deux secondes régions 7a, 7b sont en silicium amorphe dopé P. L'épaisseur des secondes régions 7a, 7b de semi-conducteur amorphe peut être comprise par exemple entre environ quelques nanomètres et quelques dizaines de nanomètres. Les secondes régions 7a, 7b de semi-conducteur amorphe peuvent être graduellement dopées (dopage le plus faible près de la face 3 du substrat 1) afin d'assurer un bon état d'interface avec le substrat semi-conducteur 1. L'épaisseur de la première région 6 peut être différente de l'épaisseur des secondes régions 7a, 7b.

Des régions de semi-conducteur intrinsèque 21a, 21b, 21c peuvent être disposées entre les régions de semi-conducteur amorphe 6, 7a, 7b et la face 3 du substrat 1, comme cela est représenté sur la figure 10. Ces régions 21e, 21b, 21c permettent d'assurer un bon état d'interface avec le substrat 1 en évitant les recombinaisons au niveau de la face 3 du substrat 1.

Intercalées entre les régions 6, 7a, 7b de semi-conducteur amorphe se trouvent des régions de diélectrique 8a, 8b, 8c, 8d. Ces régions de diélectrique 8a, 8b, 8c, 8d ont un rôle d'isolation entre deux régions de semi-conducteur amorphe ayant des types de conductivité différents. Elles permettent de ne pas provoquer de court-circuit entre ces deux régions. Ces régions isolantes 8a, 8b, 8c, 8d peuvent être par exemple de l'oxyde de silicium, du nitrure de silicium ou du silicium cristallin amorphe. Dans l'exemple illustré sur la figure 1A, l'épaisseur des régions isolantes 8e, 8b, 8c, 8d est supérieure à l'épaisseur des régions 6, 7a, 7b de semi-conducteur amorphe. Ces régions de diélectrique 8a, 8b, 8c, 8d s'étendent jusqu'au substrat 1, assurant à la fois l'isolation électrique entre les régions 6, 7e et 7b et la passivation de la surface 3 du substrat 1.

La première région 6 de semi-conducteur amorphe est connectée à au moins une première zone de métallisation 9. Cette zone de métallisation 9 est une première électrode de connexion pour le dispositif semi-conducteur 100. La première zone de métallisation 9 recouvre au moins partiellement la première région 6 de semi-conducteur amorphe.

De même, les secondes régions 7a, 7b de semi-conducteur amorphe sont connectées à au moins une seconde zone de métallisation 10a, 10b. Dans l'exemple illustré sur la figure 1A, deux secondes zones de métallisation 10a, 10b sont connectées respectivement aux deux secondes régions 7a, 7b, et les recouvrent au moins partiellement. Reliées ensemble, les secondes zones de métallisation 10a, 10b forment la deuxième électrode de connexion du dispositif semi-conducteur 100.

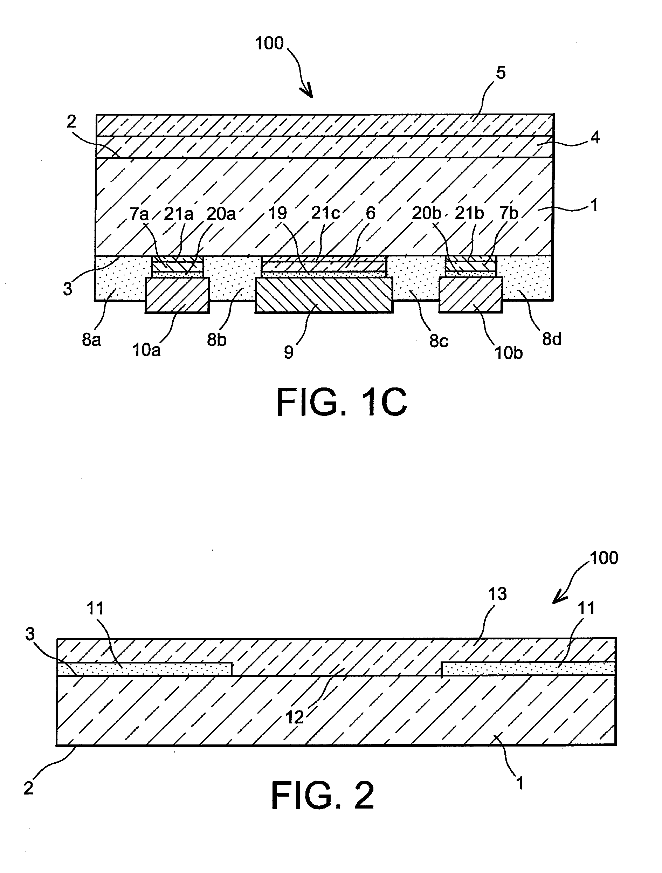

Afin d'assurer une meilleure résistivité de contact entre les zones de métallisation 9, 10a, 10b et 20 les régions de semi-conducteur amorphe 6, 7a, 7b, des zones d'oxyde thermique conducteur 19, 20a, 20b peuvent être intercalées entre les zones de métallisation 9, 10a, 10h et les régions de semi-conducteur amorphe 6, 7a, 7b. Sur la figure 1C, une première zone d'oxyde thermique conducteur 19 se trouve entre la première zone de métallisation 9 et la première région 6 de semi-conducteur amorphe. Respectivement, deux secondes zones d'oxyde thermique conducteur 20a, 20b se trouvent entre les secondes zones de métallisation 10a, 10b et les secondes régions 7a, 7b de semi-conducteur amorphe. Ces zones d'oxyde thermique conducteur 19, 20a, 20b peuvent par exemple être réalisées en oxyde d'étain et d'indium ou en oxyde de zinc.

Chacune des zones de métallisation 9, 10a, 10b peut également être en contact avec les régions 5 isolantes 8a, 8b, 8c, 8d adjacentes aux régions 6, 7a, 7b de silicium amorphe. La première zone de métallisation 9 ne doit pas être en contact avec les secondes zones de métallisation 10a, 10b car cela entraînerait un court-circuit entre les régions 6, 7a, 7b dopées de conductivité différentes.

Les zones de métallisation 9, 10a, 10b peuvent être réalisées à base d'un métal noble, tel que l'argent, ou à base d'aluminium.

Le substrat semi-conducteur 1 comporte sur une autre face 2, opposée à la face 3, une couche de passivation de surface 4. Cette couche de passivation de surface 4 permet de repousser les porteurs de charges vers la face 3 du substrat semi-conducteur 1. Cette couche de passivation de surface 4 peut être par exemple en silicium amorphe intrinsèque, ou bien en silicium amorphe dopé d'un certain type de conductivité. La techno10gie à hétérojonction permet d'utiliser des couches de passivations de surface très fines, particulièrement adaptées au silicium mince.

La couche de passivation de surface 4 est recouverte d'une couche antiréflective 5. Cette couche antiréflective 5 permet à une quantité maximale de photons de pénétrer dans le substrat semi-conducteur 1, et de ne pas les laisser sortir. La couche antiréflective 5 peut être par exemple en nitrure de silicium ou en d'autres matériaux classiquement utilisés pour cette fonction comme le fluorure de magnésium ou le sulfure de zinc.

Comme on peut le voir sur la figure 1B, les zones de métallisation 9, 10a, 10b forment chacune un doigt. Les régions isolantes 8a, 8b, 8c, 8d séparent les secondes zones de métallisation 10a, 10b de la première zone de métallisation 9. La structure ainsi formée est bien une structure inter-digitée. La première zone de métallisation 9 forme une première électrode, et les secondes zones de métallisation 10a, 10b, qui sont reliées entre elles, forment une seconde électrode.

On va maintenant s'intéresser à un premier procédé de réalisation d'un autre exemple de dispositif semi-conducteur 100, également objet de la présente invention. On suppose que le dispositif semi-conducteur 100 ainsi réalisé est une cellule solaire.

Comme on peut le voir sur la figure 2, on part d'un substrat semi-conducteur 1, par exemple en silicium de type N, que l'on suppose dans cet exemple en couche mince. Les faces du substrat semi-conducteur 1 seront identifiées par une face 3 et une autre face 2, opposée à la face 3.

Avant de procéder à la réalisation de la cellule solaire 100, le substrat semi-conducteur 1 est tout d'abord décapé sur ses faces 2 et 3. Un nettoyage RCA classique et un nettoyage à l'acide fluorhydrique sont par exemple préférables pour éviter toute contamination métallique suite à la texturation et pour la préparation des surfaces du substrat semi-conducteur 1 avant tout dépôt. Le nettoyage RCA classique consiste à utiliser un premier bain de nettoyage à base d'eau déionisée, d'ammoniaque et d'eau oxygénée, et un deuxième bain de nettoyage à base d'eau déionisée, d'acide chlorhydrique et d'eau oxygénée. L'autre face 2 peut être traitée en début ou en fin de procédé. Mais il est préférable de traiter l'autre face 2 dès le départ afin d'obtenir une meilleure qualité de passivation du fait qu'il sera difficile par la suite de réaliser un traitement à l'acide fluorhydrique sur un seul côté du silicium sans entreprendre un procédé 10ng et coûteux de protection de la face 3.

Il sera donc important de bien faire attention à l'état de la surface de l'autre face 2 au cours du traitement de la face 3.

On réalise donc sur l'autre face 2 du substrat semi-conducteur 1 un premier dépôt d'une couche de passivation de surface 4 (visible sur la figure 1).. Cette couche de passivation de surface 4 peut être par exemple une couche de silicium amorphe intrinsèque. La couche de passivation de surface 4 peut également être réalisée avec du silicium amorphe d'un certain type de conductivité. Cette couche de passivation de surface 4 s'étend sur toute la superficie de l'autre face 2 du substrat semi- 25 conducteur 1. Ce dépôt peut par exemple être réalisé par une technique de dépôt chimique en phase vapeur assisté par plasma (connu sous la dénomination ang10- saxonne PECVD pour Plasma Enhanced Chemical Vapor Deposition).

Par-dessus cette couche de passivation de surface 4, on réalise une couche antiréflective 5 (visible sur la figure 1).. Cette couche antiréflective 5 est, par exemple, du nitrure de silicium. Cette couche antiréflective 5 s'étend sur toute la surface de la couche de passivation de surface 4. Elle peut être déposée par exemple par une technique de dépôt chimique en phase vapeur à faible pression (connu sous la dénomination ang10-saxonne LPCVD pour 10w Pressure Chemical Vapor Deposition), ou bien par PECVD.

Après ces deux opérations, on réalise la face arrière du dispositif semi-conducteur 100.

On réalise une première couche isolante 11 sur l'autre face 3 du substrat semi-conducteur 1. Elle s'étend sur toute la superficie de l'autre face 3 du substrat semi-conducteur 1. Cette première couche 11 permettre d'isoler par la suite les régions de silicium amorphe de types de conductivité différents. Cette première couche isolante 11 peut être, par exemple, du nitrure de silicium. Elle peut également être réalisée avec de l'oxyde de silicium. Dans le cas d'une première couche isolante 11 en nitrure de silicium, on peut l'obtenir par LPCVD ou PECVD. Sinon, dans le cas d'une première couche isolante 11 en oxyde de silicium, sa réalisation peut s'effectuer par PECVD.

Au moins une première fenêtre 12 est ensuite gravée dans la première couche isolante 11, mettant à nu une partie du substrat semi-conducteur 1. Cette première fenêtre 12 peut être réalisée par gravure laser ou par application de pâte de sérigraphie capable de graver le matériau isolant de la première couche isolante 11.

On réalise ensuite un dépôt d'une première couche 13 de semi-conducteur amorphe dopé d'un premier type de conductivité. Ce semi-conducteur pourra par exemple être du silicium amorphe dopé N. Ce dépôt pourra par exemple être réalisé par PECVD. Dans le cas d'un dopage de type N, il pourra être réalisé par exemple avec du phosphore. Cette première couche 13 de semi-conducteur amorphe dopée N est graduellement dopée pour assurer un bon état d'interface avec le substrat semi-conducteur 1. Le dépôt de cette première couche 13 de semi-conducteur amorphe se fait à la fois dans la première fenêtre 12 et sur toute la surface de la première couche isolante 11.

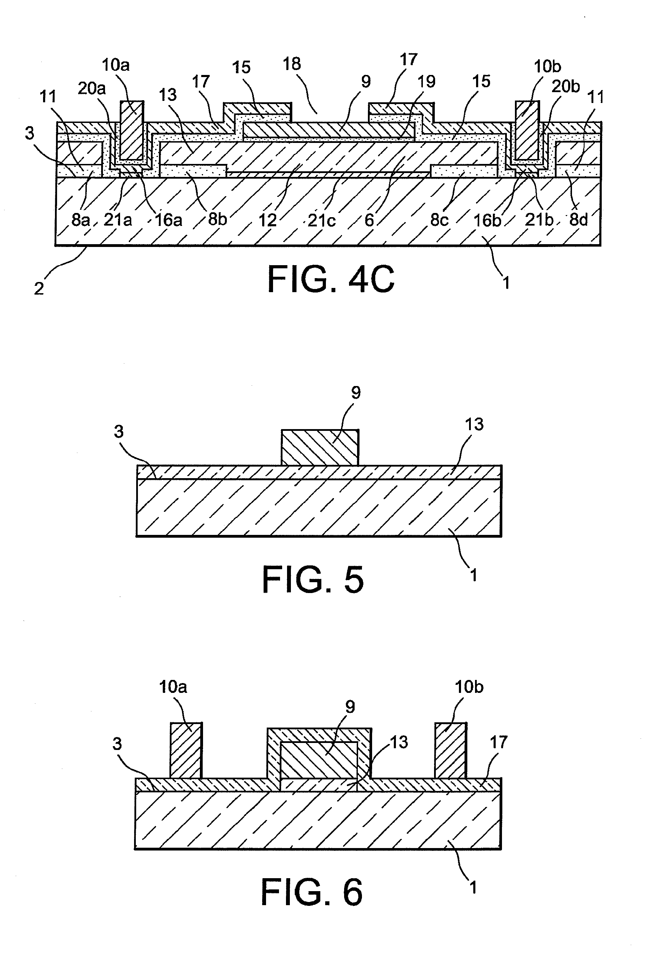

Il est également possible de réaliser, avant le dépôt de la première couche 13, un dépôt d'une première région de semi-conducteur intrinsèque 21 c, représentée sur la figure 4C, dans la première fenêtre 12. On assure ainsi un bon état d'interface avec le substrat 1 en évitant les recombinaisons au niveau de la face 3 du substrat 1.

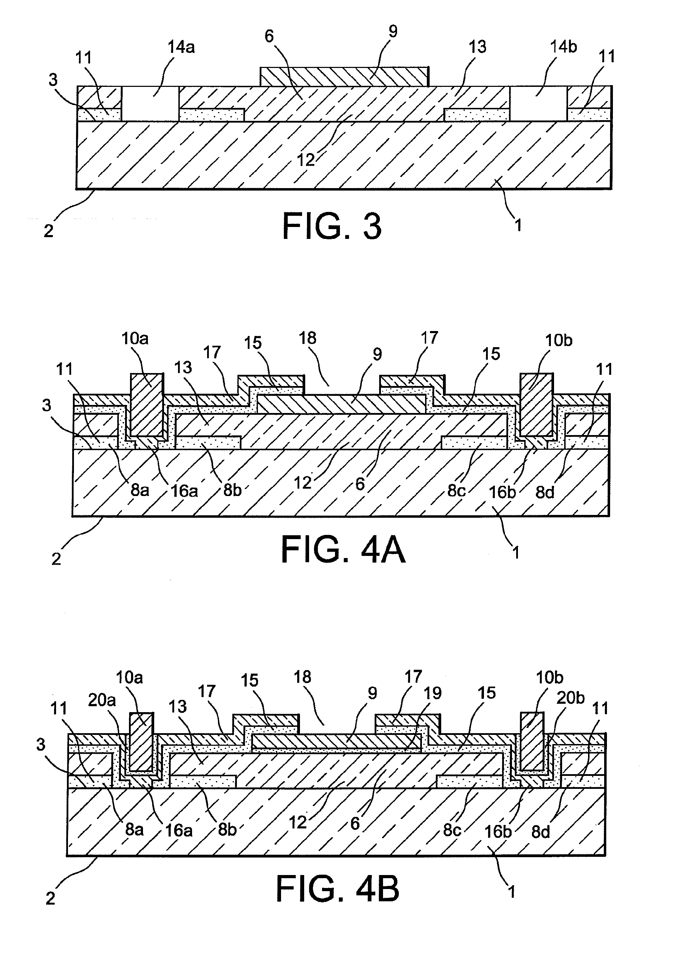

Comme on peut le voir sur la figure 3, on réalise alors le dépôt d'au moins une première zone de métallisation 9 sur la première couche 13 de semiconducteur amorphe. Cette première zone de métallisation 9 peut être, par exemple, centrée au- dessus de la première fenêtre 12. Dans l'exemple illustré sur la figure 3, la première zone de métallisation 9 a une taille inférieure à celle de la première fenêtre 12 et est centrée au-dessus d'elle. L'épaisseur de cette première zone de métallisation 9 est de quelques dizaines de micromètres environ. Le dépôt de cette première zone de métallisation 9 peut être réalisé par évaporation, pulvérisation, sérigraphie de pâtes métalliques, ou encore par dépôt électrochimique. Cette première zone de métallisation 9 est réalisée, par exemple, à base d'un métal noble tel que l'argent, ou à base d'aluminium.

Au moins une seconde fenêtre 14a, 14b est ensuite gravée dans la première couche 13 de semiconducteur amorphe et la première couche isolante 11. Dans l'exemple illustré sur la figure 3, deux secondes fenêtres 14a, 14b sont gravées dans la première couche 13 de semi-conducteur amorphe et la première couche isolante 11 de manière à mettre à nu une partie du substrat semi-conducteur 1. Ces secondes fenêtres 14a, 14b peuvent être réalisées par gravure laser ou par application de pâtes de sérigraphie capables de graver la couche de semi-conducteur amorphe 13 et la première couche isolante 11. Les secondes fenêtres 14a, 14b se trouvent décalées de part et d'autre de la première fenêtre 12. La gravure de ces deux secondes fenêtres 14a, 14b scinde en plusieurs parties la couche de semiconducteur amorphe 13, délimitant ainsi au moins une première région 6 dopée du premier type de conductivité.

Lors de la réalisation du dispositif semiconducteur 100, la gravure des secondes fenêtres 14a, 14b peut être faite avant le dépôt de la première zone de métallisation 9.

Comme on peut le voir sur la figure 4A, on réalise ensuite une seconde couche isolante 15. Cette seconde couche isolante 15 recouvre la première zone de métallisation 9, la première couche 13 de semiconducteur amorphe, ainsi que les parties du substrat semi-conducteur 1 mis à nu par les secondes fenêtres 14a, 14b. Cette seconde couche isolante 15 peut être, par exemple, du nitrure de silicium. Elle peut également être réalisée par une couche d'oxyde de silicium. Dans le cas d'une seconde couche isolante 15 en nitrure de silicium, on peut l'obtenir par LPCVD ou PECVD. Enfin, dans le cas d'une seconde couche isolante 15 en oxyde de silicium, sa réalisation peut s'effectuer par PECVD.

On grave alors au moins une première ouverture 16a, 16b dans la seconde couche isolante 15, au niveau des deux secondes fenêtres 14a, 14b, mettant à nu une partie du substrat semi-conducteur 1. Dans l'exemple illustré sur la figure 4A, deux premières ouvertures I6a, 16b sont réalisées et chacune des cieux premières ouvertures 16a, 16b a une superficie plus petite que leur seconde fenêtre respective 14a, 14b. Ces deux premières ouvertures 16a, 16b peuvent être réalisées par gravure laser ou par sérigraphie de pâtes gravantes. La gravure de ces deux premières ouvertures 16a, 16b scinde les couches isolantes 11 et 15 en plusieurs parties, délimitant ainsi les régions isolantes 8a, 8h, 8c, 8d.

On réalise ensuite le dépôt d'une seconde couche 17 de semi-conducteur amorphe dopée d'un second type de conductivité, opposé au premier type de conductivité. Ce semi-conducteur pourra donc par exemple être du silicium amorphe dopé P. Ce dépôt pourra par exemple être réalisé par PECVD. Dans le cas d'un dopage de type P, il pourra être réalisé par exemple avec du bore. Cette seconde couche 17 de semiconducteur amorphe dopée P est graduellement dopée pour assurer un bon état d'interface avec le substrat semi-conducteur 1. Le dépôt de cette seconde couche 17 de semi-conducteur amorphe se fait à la fois dans les premières ouvertures 16a, 16b mais également sur toute la surface de la seconde couche Isolante 15. La première couche 13 de semi-conducteur amorphe et la seconde couche 17 de semi-conducteur amorphe forme une structure inter-digitée, ayant un contour délimité lors de la gravure de la première fenêtre 12 et des premières ouvertures 16a, 16b.

Il est également possible de réaliser, 15 avant le dépôt de la seconde couche 17, un dépôt de secondes régions de semi-conducteur intrinsèque 21 a, 21 b, représentées sur la figure 4C, dans les premières ouvertures 16a, 16b. Comme la région 21 c, les régions de semi-conducteur intrinsèque 21 a, 21h assurent un bon état d'interface avec le substrat 1 en évitant les recombinaisons au niveau de la face 3 du substrat 1.

On réalise ensuite le dépôt d'au moins une seconde zone de métallisation 10a, 10h sur la couche de semi-conducteur amorphe 17, dans les secondes fenêtres 14a, 14b, au moins au niveau des premières ouvertures 16a, 16b. Dans l'exemple illustré sur la figure 4A, deux secondes zones de métallisation 10a, 10b sont réalisées. Le dépôt de ces secondes zones de métallisation 10a, 10b peut être réalisé par évaporation, pulvérisation, sérigraphie de pâtes métalliques, ou encore par dépôt électrochimique. Ces secondes zones de métallisation 10a, 1Db sont réalisées, par exemple, à base d'un métal noble tel que l'argent, ou à base d'aluminium.

Enfin, au moins une seconde ouverture 18 est gravée dans la seconde couche 17 de semi-conducteur amorphe et la seconde couche isolante 15, au dessus de la première zone de métallisation 9. Cette seconde ouverture 18 est réalisée pour accéder à la première zone de métallisation 9. on gravera de préférence une seconde ouverture 18 ayant une superficie plus petite que celle de la première zone de métallisation 9 et étant centrée au dessus de cette première zone de métallisation 9. Cette seconde ouverture 18 peut être réalisée par gravure laser ou par application de pâtes de sérigraphie capables de graver la seconde couche 17 de semi-conducteur amorphe et la seconde couche isolante 15.

En outre, dans l'ensemble des réalisations décrites, on pourra avantageusement prévoir d'intercaler entre les couches de silicium amorphe 13, et les métallisations 9, 10a, 10b des zones 19, 20a, 20b d'oxyde thermique conducteur, comme cela est représenté sur les figures 4B et 4C. Ces zones 19, 20a, 20b d'oxyde thermique conducteur peuvent être par 25 exemple en oxyde d'étain et d'indium ou en oxyde de zinc. Ces zones permettent d'assurer une meilleure résistivité de contact entre les métallisations 9, 10a, 10b et le semi-conducteur amorphe 13, 17.

Les figures 5, 6, 7A et 7B représentent les étapes d'un second procédé de réalisation d'un autre exemple de dispositif semi-conducteur 100, également objet de la présente invention. On suppose que le dispositif semi-conducteur 100 ainsi réalisé est une cellule solaire.

Ce procédé fait appel à un substrat semi-conducteur 1 identique à celui utilisé dans le premier procédé, objet de la présente invention. Comme pour le premier procédé, il est possible de décaper les faces 2 et 3 du substrat 1 par un nettoyage RCA classique et un nettoyage à l'acide fluorhydrique. Il est également possible de réaliser sur l'autre face 2 du substrat 1 une couche de passivation de surface 4 et une couche anti-réflective 5, visibles sur la figure 1.

Comme on peut le voir sur la figure 5, on réalise un dépôt d'une première couche 13 de semi-conducteur amorphe dopé d'un premier type de conductivité sur la face 3 du substrat 1. Ce semi-conducteur pourra par exemple être du silicium amorphe dopé N. Ce dépôt pourra par exemple être réalisé par PECVD. Dans le cas d'un dopage de type N, il pourra être réalisé par exemple avec du phosphore. Cette première couche 13 de semi-conducteur amorphe dopée N peut être graduellement dopée pour assurer un bon état d'interface avec le substrat semi-conducteur 1. Le dépôt de cette première couche 13 de semi-conducteur amorphe se fait sur toute la face 3 du substrat 1.

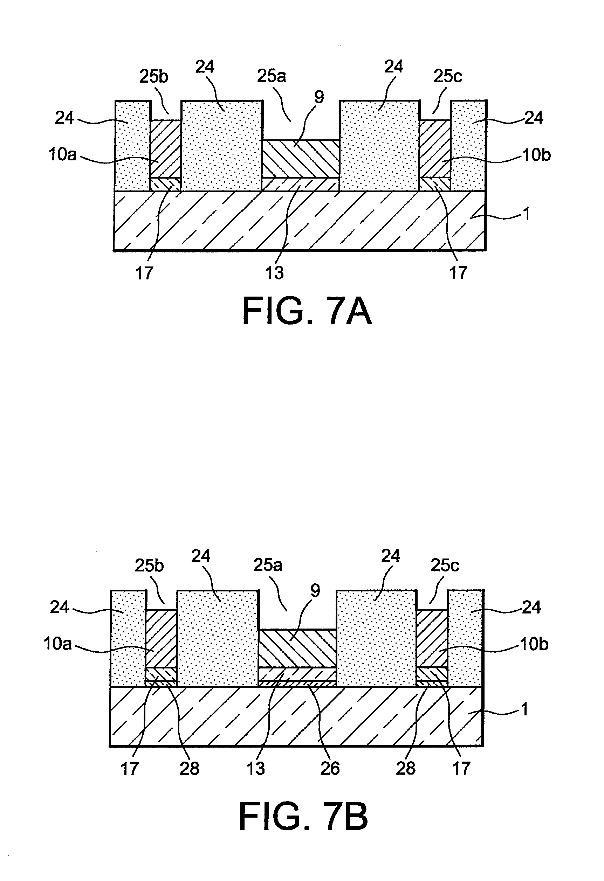

Il est également possible de réaliser, avant le dépôt de la première couche 13, un dépôt d'une première couche de semi-conducteur intrinsèque 26, représentée sur la figure 7B. On assure ainsi un bon état d'interface avec le substrat 1 en évitant les recombinaisons au niveau de la face 3 du substrat 1.

On réalise ensuite le dépôt d'au moins une première zone de métallisation 9 sur la première couche 13 de semi-conducteur amorphe. L'épaisseur de cette première zone de métallisation 9 est de quelques dizaines de micromètres environ. Le dépôt de cette première zone de métallisation 9 peut être réalisé par évaporation, pulvérisation, sérigraphie de pâtes métalliques, ou encore par dépôt électrochimique. Cette première zone de métallisation 9 est réalisée, par exemple, à base d'un métal noble tel que l'argent, ou à base d'aluminium.

On élimine alors des zones de la première couche 13 de semi-conducteur amorphe, et éventuellement de la couche de semi-conducteur intrinsèque 26, non recouvertes par la première zone de métallisation 9. Cette étape peut par exemple être réalisée par gravure sèche ou humide, ou encore par gravure sélective permettant de ne graver que le semi-conducteur amorphe et non le métal.

Comme on peut le voir sur la figure 6, on réalise ensuite le dépôt d'une seconde couche 17 de semi-conducteur amorphe dopée d'un second type de conductivité, opposé au premier type de conductivité. Ce semi-conducteur pourra donc par exemple être du silicium amorphe dopé P. Ce dépôt pourra par exemple être réalisé par PECVD. Dans le cas d'un dopage de type P, il pourra être réalisé par exemple avec du bore. Cette seconde couche 17 de semi-conducteur amorphe dopée P peut être graduellement dopée pour assurer un bon état d'interface avec le substrat semi-conducteur 1.

Là encore, il est également possible de réaliser, avant le dépôt de la seconde couche 17 de semi-conducteur amorphe, un dépôt d'une seconde couche de semi-conducteur intrinsèque 28, représentée sur la figure 7B.

On réalise ensuite le dépôt de secondes zones de métallisation 10a, 10b sur la couche de semi-conducteur amorphe 17. Dans l'exemple illustré sur la figure 6, deux secondes zones de métallisation 10a, 10b sont réalisées sur la seconde couche 17 de semiconducteur amorphe. Le dépôt de ces secondes zones de métallisation 10a, 10b peut être réalisé par évaporation, pulvérisation, sérigraphie de pâtes métalliques, ou encore par dépôt électrochimique. Ces secondes zones de métallisation 10a, 10b sont réalisées, par exemple, à base d'un métal noble tel que l'argent, ou à base d'aluminium.

On élimine alors les zones de la seconde couche 17 de semi-conducteur amorphe, et éventuellement de la seconde couche de semi-conducteur intrinsèque 28, non recouvertes par les secondes zones de métallisation 10a, 10b. Cette étape peut par exemple être réalisée 25 par gravure sèche ou humide ou par gravure sélective en ne gravant que le semi-conducteur et non le métal des métallisations 10a, 10b.

On dépose ensuite une couche isolante 24, par exemple de diélectrique, sur la face 3 du substrat 1 et sur les métallisations 9, 10a, 10b.

On réalise alors des ouvertures 25a, 25b, 25c dans la couche isolante 24, au niveau des métallisations 9, 10a, 10b. Ainsi, les métallisations 9, 10a, 10b deviennent accessibles depuis l'environnement extérieur.

En outre, dans l'ensemble des réalisations décrites, on pourra avantageusement prévoir d'intercaler entre les couches de silicium amorphe 13, 17 et les métallisations 9, 10a, 10b des zones 19, 20a, 20b d'oxyde thermique conducteur, comme cela est représenté sur les figures 4B et 4C. Ces zones 19, 20a, 20b d'oxyde thermique conducteur peuvent être par exemple en oxyde d'étain et d'indium ou en oxyde de zinc. Ces zones permettent d'assurer une meilleure résistivité de contact entre les métallisations 9, 10a, 10b et le semi-conducteur amorphe 13, 17.

Comme l'illustre la figure 5, plusieurs dispositifs semi-conducteurs 101 à 109, conformes à l'invention peuvent être réalisés en même temps sur le substrat semi-conducteur 1. Les dispositifs unitaires peuvent ensuite connectés entre eux par leurs zones de métallisation pour obtenir un module 200 de cellules solaires. Dans notre exemple illustré sur la figure 5, les dispositifs 101 à 103 sont connectés en série, de même que les dispositifs 104 à 106 et les dispositifs 107 à 109. Les trois groupes de cellules reliées en série ainsi formés sont connectés alors en parallèle.

Bien que plusieurs modes de réalisation de la présente invention aient été décrits de façon détaillée, on comprendra que différents changements et modifications puissent être apportés sans sortir du cadre de l'invention. Dans les exemples décrits, le premier type de conductivité est de type N et le second type P. Il est bien sûr possible que ce soit l'inverse, l'homme du métier n'ayant aucun problème pour choisir des matériaux appropriés conduisant à ces conductivités.

## Revendications

1. Dispositif semi-conducteur (100) comprenant, sur au moins une face (3) d'une couche (1) en un matériau semi-conducteur cristallin d'un certain type de conductivité, une couche (6 ; 7a ; 7b) en un matériau semi-conducteur amorphe, dopé d'un type de conductivité opposé au type de conductivité de la couche (1) d'un matériau semi-conducteur cristallin, **caractérisé en ce que** la concentration des éléments dopants varie graduellement dans la couche (6 ;7a ;7b) de semi-conducteur amorphe.

2. Dispositif selon l'une quelconque des revendications précédentes, **caractérisé en ce que** ladite concentration des éléments dopants augmente progressivement dans la couche (6 ; 7a ; 7b) de semi-conducteur amorphe à partir de la couche (1) de semi-conducteur cristallin.

3. Dispositif selon l'une quelconque des revendications précédentes, **caractérisé en ce que** la couche (6 ; 7a ; 7b) de semi-conducteur amorphe est en silicium.

4. Dispositif selon la revendication précédente, **caractérisé en ce que** la couche (1) de semi-conducteur cristallin est en silicium monocristallin ou polycristallin.

5. Dispositif selon l'une quelconque des revendications précédentes, **caractérisé en ce qu'**il comprend une zone de métallisation (9 ; 10a ; 10b) sur la couche (6 ; 7a ; 7b) de semi-conducteur amorphe.

6. Dispositif selon la revendication 5, **caractérisé en ce qu'**il comprend une zone d'oxyde thermique conducteur (19 ; 20a ; 20b) entre la zone de métallisation (9 ; 10a ; 10b) et la couche (6 ; 7a ; 7b) de semi-conducteur amorphe.

7. Dispositif selon la revendication 7 **caractérisé en ce que** la zone d'oxyde thermique (19 ; 20a ; 20b) est en oxyde conducteur transparent tel l'oxyde d'étain et d'indium.

8. Dispositif selon l'une quelconque des revendications précédentes **caractérisé en ce que** le dispositif est une cellule solaire.

9. Procédé pour réaliser un dispositif semi-conducteur, **caractérisé en ce qu'**il comprend les étapes suivantes :
(a) fournir une première couche en matériau semi-conducteur cristallin, et
(b) déposer un matériau semi-conducteur amorphe sur la couche de matériau semi-conducteur cristallin, de sorte à former une deuxième couche présentant une discontinuité de bandes avec la première couche, la couche de matériau semi-conducteur amorphe étant graduellement dopée.
